(19) Europäisches Patentamt
European Patent Office
Office européen des brevets

(11) **EP 1 983 563 A1**

(12) **EUROPEAN PATENT APPLICATION**
published in accordance with Art. 158(3) EPC

(43) Date of publication:
**22.10.2008 Bulletin 2008/43**

(51) Int Cl.:
*H01L 21/338* (2006.01)   *H01L 29/06* (2006.01)
*H01L 29/778* (2006.01)   *H01L 29/80* (2006.01)
*H01L 29/812* (2006.01)

(21) Application number: **07706287.5**

(22) Date of filing: **29.01.2007**

(86) International application number:
**PCT/JP2007/000037**

(87) International publication number:
**WO 2007/091383 (16.08.2007 Gazette 2007/33)**

(84) Designated Contracting States:
**DE**

(30) Priority: **10.02.2006   JP 2006034252**

(71) Applicant: **NEC Corporation**
**Minato-ku**
**Tokyo 108-8001 (JP)**

(72) Inventors:
• **ANDO, Yuji**
  **Tokyo 108-8001 (JP)**
• **MIYAMOTO, Hironobu**
  **Tokyo 108-8001 (JP)**
• **OKAMOTO, Yasuhiro**
  **Tokyo 108-8001 (JP)**
• **NAKAYAMA, Tatsuo**
  **Tokyo 108-8001 (JP)**
• **INOUE, Takashi**
  **Tokyo 108-8001 (JP)**

(74) Representative: **Betten & Resch**
**Patentanwälte**
**Theatinerstrasse 8**
**(Fünf Höfe)**
**80333 München (DE)**

(54) **SEMICONDUCTOR DEVICE**

(57)    An electron supply layer (13) is a layer which forms a heterojunction with a channel layer (12) and contains $In_zAl_xGa_{1-z-x}N$ ($0 \leq z < 1$, $0 < x < 1$, and $0 < x+z < 1$). On the electron supply layer (13), a gate electrode (17) is formed in contact with the electron supply layer (13). An Al composition ratio $x_1$ at an interface between the electron supply layer (13) and the channel layer (12) and an Al composition ratio $x_a$ at an interface between the electron supply layer (13) and the gate electrode (17) satisfy the following conditions:
$x_1/2 \leq x_a < x_1$ and
$x_1 \leq 0.3$.

FIG. 1

**Description**

TECHNICAL FIELD

The present invention relates to semiconductor devices and, more particularly, relates to a heterojunction field effect transistor (HJFET) which contains a III group nitride semiconductor as a material.

BACKGROUND ART

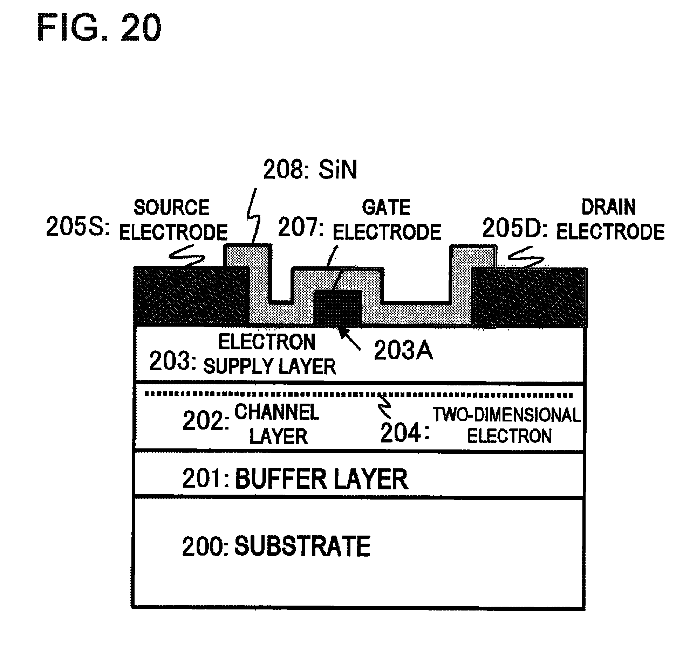

Fig. 20 is a view showing a cross sectional structure of an HJFET according to a related art. Such an HJFET is reported in a non-patent document 1, for example.

In Fig. 20, reference numeral 200 denotes a substrate, 201 denotes a buffer layer, 202 denotes a gallium nitride (GaN) channel layer, and 203 denotes an aluminum gallium nitride ($Al_bGa_{1-b}N$ (b is constant)) electron supply layer. With piezo polarization effects and spontaneous polarization effects, both being caused by a lattice constant difference between GaN and AlGaN, a two-dimensional electron gas 204 is formed in the vicinity of an interface between the GaN channel layer 202 and the AlGaN electron supply layer 203. A source electrode 205S and a drain electrode 205D are formed in contact with the AlGaN electron supply layer 203, and ohmic contacts are formed therebetween. A gate electrode 207 is formed at a portion sandwiched between the source electrode 205S and the drain electrode 205D on the AlGaN electron supply layer 203; and a Schottky contact is formed at an interface 203A. Furthermore, a surface protective film (dielectric film) 208 made of silicon nitride (SiN) is formed on the gate electrode 207.

With spontaneous polarization between a III group atom and an N atom and piezo polarization based on a lattice constant difference between AlGaN and GaN, a polarization charge is generated at an AlGaN/GaN hetero interface. It is known that polarization charge density $\sigma$ at this time can be approximated by the following equation as a function of an Al composition ratio b of the AlGaN layer.

$$\sigma/q = \alpha b \qquad (Equation\ 1)$$

In this case, q (=$1.6 \times 10^{-19}$ C) is an elementary charge, and $\alpha$ (=$5.6 \times 10^{13}$ cm$^{-2}$) is a proportionality coefficient. As for symbols of the polarization charge, in the case of Ga-face growth, an AlGaN interface on GaN is positive, and a GaN interface on AlGaN is negative.

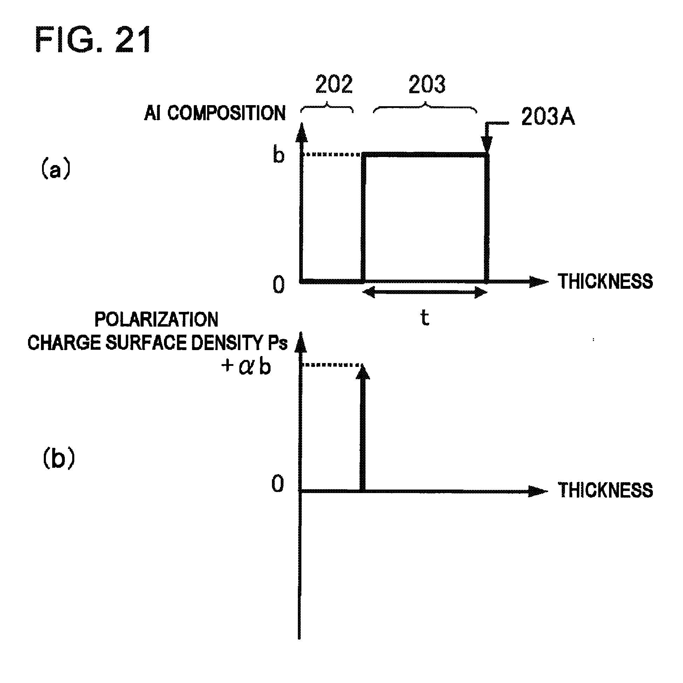

Fig. 21(a) is a view showing the distribution of an Al composition ratio in a direction perpendicular to the substrate in the HJFET shown in FIG. 20, and (b) is a typical view of the distribution of polarization charge density in the direction perpendicular to the substrate in the HJFET shown in FIG. 20. In this structure, an Al composition ratio b in the AlGaN electron supply layer 203 is uniform. That is, an Al composition ratio at the channel end ($x_1$) is equal to an Al composition ratio at the gate end ($x_a$). For example, to mention a single example, it is set to $x_1 = x_a = 0.2$. In this case, as is apparent from Equation 1, a positive polarization charge of approximately $1.1 \times 10^{13}$ cm$^{-2}$ is generated at the interface between the GaN channel layer 202 and the AlGaN electron supply layer 203. This positive charge is the cause of the generation of the two-dimensional electron gas 204.

Non-patent document 1: International Electron Devices Meeting, 2001, Technical Digest (IEDM 01-381 to 384), Y. Ando

DISCLOSURE OF THE INVENTION

It is known that the influence of pinning of a Fermi level is small at a Schottky interface between an electron supply layer of a III group nitride semiconductor and a gate electrode; and therefore, the barrier height is determined by a difference between a work function of a metal and an electronic affinity of the semiconductor. Therefore, for example, the Schottky barrier height in the electron supply layer made of an AlGaN layer with an Al composition ratio of 0.2 is slightly dependent on the electrode metal; however, it becomes relatively low, approximately 0.8 to 1.0 eV. Therefore, there is a problem in that the III group nitride based HJFET using AlGaN as the electron supply layer has high gate leak current density and operation drain voltage is limited.

According to the present invention, there is provided a semiconductor device which includes a channel layer; an electron supply layer which forms a heterojunction with the channel layer, and contains $In_zAl_xGa_{1-z-x}N$ ($0 \leq z < 1$, $0 < x < 1$, and $0 < x+z < 1$); and a source electrode, a drain electrode, and a gate electrode, those of which are formed in contact with the electron supply layer. In the semiconductor device, an Al composition ratio $x_1$ ($x_1 > 0$) at an interface between the electron supply layer and the channel layer, and an Al composition ratio $x_a$ ($x_a > 0$) at an interface between the electron supply layer and the gate electrode are set to

$x_1/2 \leq x_a < x_1$, and
$x_1 \leq 0.3$.

According to a semiconductor device of this configuration, an Al composition ratio $x_1$ ($x_1 > 0$) at an interface with a channel layer of an electron supply layer and an Al composition ratio $x_a$ ($x_a > 0$) at an interface with a gate electrode of an electron supply layer are $x_1/2 \leq x_a < x_1$ and $x_1 \leq 0.3$; and therefore, there may be provided a semiconductor device which may reduce a gate leak current.

According to the present invention, there is provided a semiconductor device which may reduce a gate leak current.

BRIEF DESCRIPTION OF THE DRAWINGS

The above and other objects, advantages, and features of the present invention will be more apparent from the following description of certain preferred embodiments taken in conjunction with the accompanying drawings, in which:

Fig. 1 is a cross sectional view showing a configuration of an HJFET according to a first implemental examples of the present invention;

Fig. 2(a) is a view showing the distribution of Al composition ratios in a direction perpendicular to a substrate in the HJFET shown in Fig. 1, and (b) is a typical view of the distribution of polarization charge densities in the direction perpendicular to the substrate;

Fig. 3 is a view showing conduction band energy distributions;

Fig. 4 is a view showing dependent properties of Al composition ratios at the gate end ($x_a$) of a gate leak current;

Fig. 5 is a view showing dependent properties of Al composition ratios of the amount of variation of a maximum drain current $I_{max}$;

Fig. 6 is a view showing dependent properties of A1 composition ratios of a threshold voltage $V_{th}$;

Fig. 7(a) shows a view showing the distribution of Al composition ratios in a direction perpendicular to a substrate in an HJFET of a second implemental example, (b) is a typical view of the distribution of polarization charge surface densities of the second implemental example;

Fig. 8 is a view showing a cross sectional structure of an HJFET of a third implemental example;

Fig. 9 is a typical view of the distribution of Al composition ratios in a direction perpendicular to a substrate in a third implemental example;

Fig. 10 is a view showing dependent properties of Al composition ratios at the gate end $x_a$ of a gate leak current measured in the HJFET of the third implemental example;

Fig. 11 is a view showing dependent properties of Al composition ratios at the gate end $x_a$ of an $I_{max}$ measured in the HJFET of the third implemental example;

Fig. 12 is a view showing dependent properties of Al composition ratios at the gate end $x_a$ of a threshold voltage $V_{th}$ of the third implemental example;

Fig. 13(a) shows a view showing the distribution of Al composition ratios in a direction perpendicular to a substrate in an HJFET of a fourth implemental example, (b) is a typical view of the distribution of polarization charge densities of the fourth implemental example;

Fig. 14(a) shows a view showing the distribution of Al composition ratios in a direction perpendicular to a substrate in an HJFET of a fifth implemental example, (b) is a typical view of the distribution of polarization charge densities of the fifth implemental example;

Fig. 15 is a view showing the distribution of Al composition ratios in a direction perpendicular to a substrate in an HJFET of a sixth implemental example;

Fig. 16 is a view showing the distribution of Al composition ratios in a direction perpendicular to a substrate in an HJFET of a seventh implemental example;

Fig. 17 is a view showing the distribution of Al composition ratios in a direction perpendicular to a substrate in an HJFET of an eighth implemental example;

Fig. 18 is a cross sectional view showing an HJFET according to a ninth implemental example;

Fig. 19 is a cross sectional view showing an HJFET according to a tenth implemental example;

Fig. 20 is a cross sectional view showing a configuration of a known HJFET; and

Fig. 21(a) shows a view showing the distribution of an Al composition ratio in a direction perpendicular to a substrate in a known HJFET, (b) is a typical view of the distribution of polarization charge density of the known HJFET.

BEST MODE FOR CARRYING OUT THE INVENTION

First, in order to facilitate understanding of the present invention, a general outline of the present invention will be described.

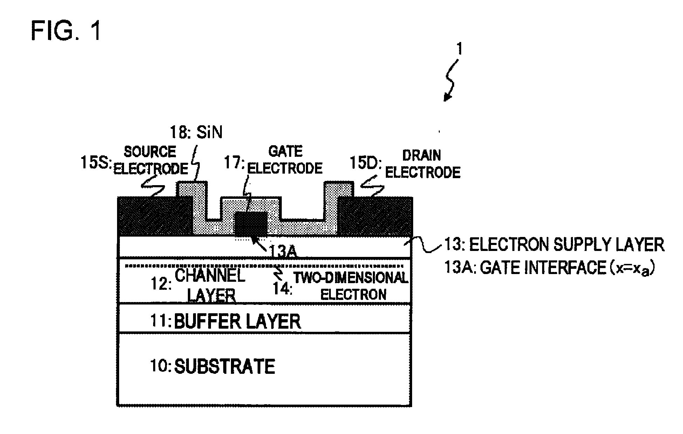

Fig. 1 shows an HJFET (semiconductor device) 1 as one example of a semiconductor device according to the present invention.

The HJFET 1 has a silicon carbide (SiC) substrate 10; a buffer layer 11 made of an aluminum nitride (AlN) layer which is stacked on the silicon carbide (SiC) substrate 10, a channel layer 12 made of $In_yGa_{1-y}N$ ($0 \leq y \leq 1$) (in this case, made of undoped GaN) which is stacked on the buffer layer 11; an electron supply layer 13 stacked on the channel layer 12; and a gate electrode 17, a source electrode 15S, and a drain electrode 15D, those of which are formed in contact with the electron supply layer 13 on the electron supply layer 13.

The electron supply layer 13 is a layer which forms a heterojunction with the channel layer 12 and contains $In_zAl_xGal_{1-z-x}N$ ($0 \leq z < 1$, $0 < x < 1$, $0 < x+z < 1$). In the present embodiment, the electron supply layer 13 is an undoped $Al_xGa_{1-x}N$ ($0 < x < 1$) layer, and Al composition ratios x are continuously inclined and reduced from the channel layer 12 side toward the gate electrode 17 side.

An Al composition ratio at an interface between the electron supply layer 13 and the channel layer 12 is $x_1$, and an Al composition ratio at a surface of the electron supply layer 13 is $x_2$. In the present embodiment, the gate electrode 17 is in contact with the surface of the electron supply layer 13; and therefore, an Al composition ratio $x_a$ at an interface between the electron supply layer 13 and the gate electrode 17 is equal to $x_2$ ($x_1 > x_2$).

With piezo polarization effects and spontaneous polarization effects, both being caused by a lattice constant difference between GaN and AlGaN, a two-dimensional electron gas 14 is formed in the vicinity of the interface between the channel layer 12 and the AlGaN layer 13.

The before mentioned source electrode 15S and the drain electrode 15D are formed on the electron supply layer 13, and ohmic contacts are formed.

The gate electrode 17 is formed at a portion sandwiched between the source electrode 15S and the drain electrode 15D on the AlGaN electron supply layer 13; and a Schottky contact is formed at the interface 13A (Al composition ratio: $x=x_a=x_2$). The semiconductor device 1 is operated as a transistor by modulating two-dimensional electron gas concentration at a potential of the gate electrode 17. In addition, reference numeral 18 denotes a surface protective film (dielectric film) made of SiN.

In this case, in the present embodiment, the Al composition ratio $x_1$ at the interface between the electron supply layer 13 and the before mentioned channel layer 12 and the Al composition ratio $x_a$ at the interface between the before mentioned electron supply layer 13 and the gate electrode 17 satisfy the following Equations 2 and 3.

$$x_1/2 \leq x_a < x_1 \quad (Equation\ 2)$$

$$x_1 \leq 0.3 \quad (Equation\ 3)$$

Regarding the conditions (Equations 2 and 3), the following study will be made.

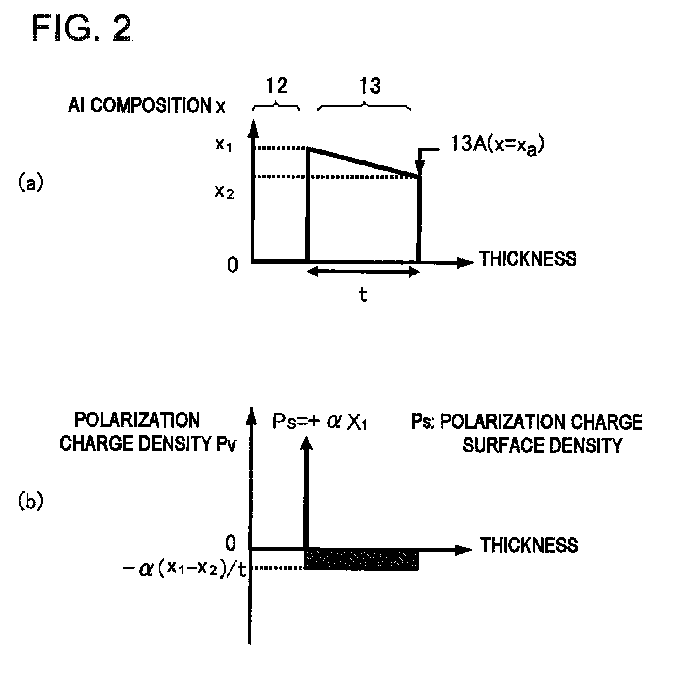

Fig. 2(a) is a view showing the distribution of Al composition ratios in a direction perpendicular to the substrate 10 in the HJFET 1 shown in Fig. 1, and Fig. 2(b) is a typical view of the distribution of polarization charge densities in the direction perpendicular to the substrate 10.

A gate interface 13A is a surface of the electron supply layer 13; and therefore, the Al composition ratio $x_a$ of the interface 13A coincides with the Al composition ratio $x_2$ at the AlGaN surface. According to Equation 1, a positive polarization charge whose surface density (Ps) is represented by the following equation is discretely generated at the interface between the channel layer (GaN layer) 12 and the electron supply layer 13 that is AlGaN.

$$Ps = +\alpha x_1$$

In the case where the GaN layer is stacked on the AlGaN layer, a negative polarization charge is discretely generated at its hetero interface. Therefore, if the Al composition ratios are continuously reduced in the electron supply layer 13 from $x=x_1$ to $x=x_2$ ($<x_1$), the negative polarization charge is continuously generated in the electron supply layer 13. According to Equation 1, volume density (Pv) of the polarization charge is represented by the following equation:

$$Pv = -\alpha (x_1 - x_2)/t,$$

where, t is a film thickness of the electron supply layer 13.

The negative polarization charge is generated in the electron supply layer 13; and accordingly, it is presumed that an electron barrier at the Schottky interface becomes thick and a gate tunnel current can be suppressed.

Corroboration of this presumption will be described in the following.

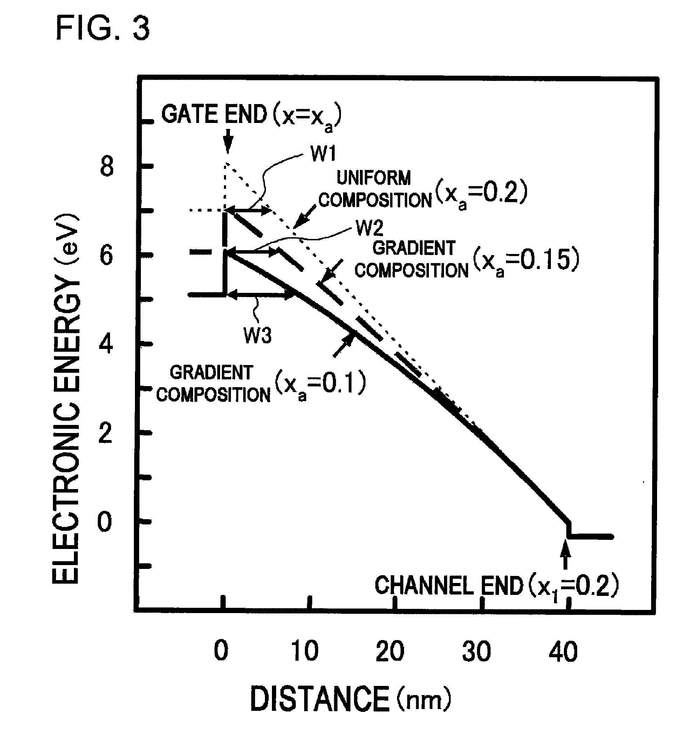

A conduction band energy distribution is calculated by solving a Poisson equation. Fig. 3 is one example of conduction band energy distributions in the direction perpendicular to the substrate 10. There are shown triplicate results in the case where the Al composition ratios are uniform ($x_1=x_a=0.2$), in the case where the Al composition ratios are continuously decreased from 0.2 to 0.15 ($x_1=0.2$ and $x_a=0.15$), and in the case where the Al composition ratios are continuously decreased from 0.2 to 0.1 ($x_1=0.2$ and $x_a=0.1$). In this case, the case where the compositions are uniform ($x_1=x_a=0.2$) corresponds to the related art shown in Fig. 20.

In the case where the Al composition ratios are uniform, a linear conduction band energy distribution can be obtained in the AlGaN layer. Therefore, an electron tunnel barrier at the gate interface becomes thin and the tunnel current is increased. In Fig. 3, W1 shows the thickness of the tunnel barrier in the case where the Al composition ratios are uniform.

On the other hand, in the case where the Al composition ratios are reduced from 0.2 to 0.15, conduction band energy distributions which are convexly curved upward can be obtained caused by the negative polarization charge. Therefore, the electron tunnel barrier at the gate interface becomes thick, and the tunnel current is decreased. Also in the case where the Al composition ratios are decreased from 0.2 to 0.1, conduction band energy distributions which are convexly curved can be obtained caused by the negative polarization charge. Then, the electron tunnel barrier at the gate interface further becomes thick, and the tunnel current is further decreased. In Fig. 3, W2 shows the thickness of the tunnel barrier in the case where the Al composition ratios are decreased from 0.2 to 0.15; and W3 shows the thickness of the tunnel barrier in the case where the Al composition ratios are decreased from 0.2 to 0.1.

As described above, it is set to $x_a<x_1$ and the negative polarization charge is generated in the electron supply layer 13; and accordingly, it can be seen that the barrier of an electron at the Schottky interface becomes thick and the gate tunnel current can be suppressed.

In addition, in this case, there is exemplified the case where the Al composition ratios are continuously decreased; however, if it is set to $x_a<x_1$ and the negative polarization charge is generated in the electron supply layer 13, the electron tunnel barrier at the gate interface becomes thick, and the gate tunnel current can be suppressed.

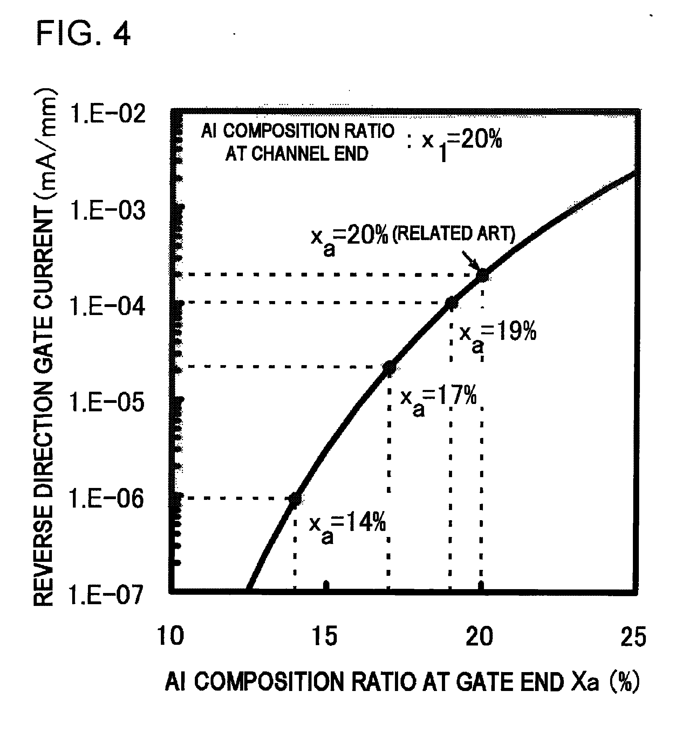

Further, the density of a tunnel current flowing through the electron supply layer is calculated. Fig. 4 is dependent properties of Al composition ratios at the gate end ($x_a$) of a gate leak current estimated from the tunnel current density. In this case, an Al composition ratio at the channel end $x_1$ is fixed to 0.2. The gate leak current is exponentially decreased together with a decrease of the Al composition ratio $x_a$.

That is, if it is set to

$$x_a < x_1 \quad (\text{Equation 4}),$$

the gate leak current is more suppressed than the related art. It turns out from Fig. 4 that in the case where it is set to $x_1=0.2$ and $x_a<0.19$, the gate leak current is suppressed to approximately equal to or less than 50% as compared with the related art ($x_1=x_a=0.2$). Therefore, a desirable relation of the Al composition ratios ($x_1$ and $x_a$) to obtain a remarkable gate leak current suppression effect is in the following equation.

$$x_1 - x_a > 0.01$$

In addition, the relation of $x_1-x_a>0.01$ is not limited to the case where it is set to $x_1=0.2$; but, it does not depend on the composition ratio of $x_1$.

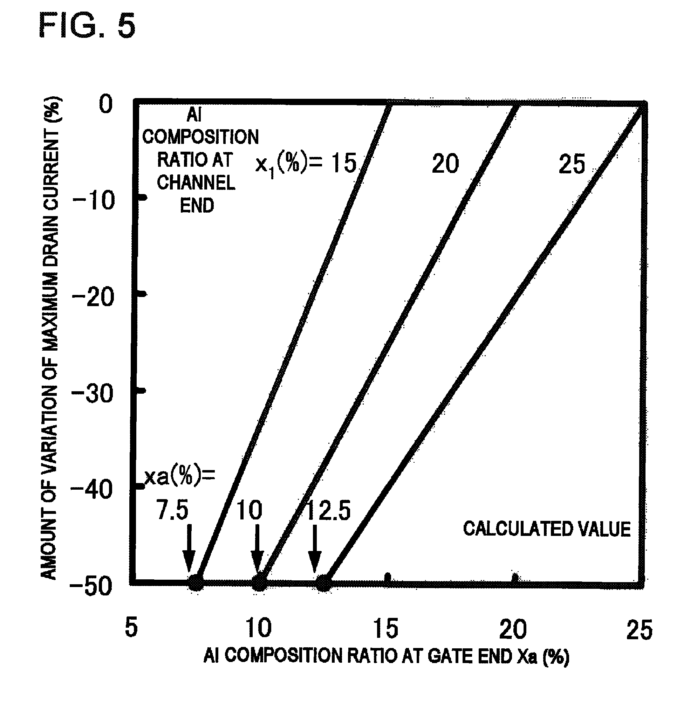

Next, dependent properties of Al composition ratios of maximum drain currents $I_{max}$ are calculated. Fig. 5 is dependent properties of Al composition ratios at the gate end $x_a$ of the amount of variation of the calculated $I_{max}$. $I_{max}$ is decreased with a decrease of the Al composition ratio $x_a$. However, if it is set to

$$x_1/2 \leq x_a \quad (\text{Equation 5}),$$

a decrease width of $I_{max}$ is suppressed to within 50%. A decrease of $I_{max}$ in excess of 50% causes a remarkable decrease of a current drive power; and therefore, it is preferable that Equation 5 is set as a lower limit of the Al composition ratio $x_a$.

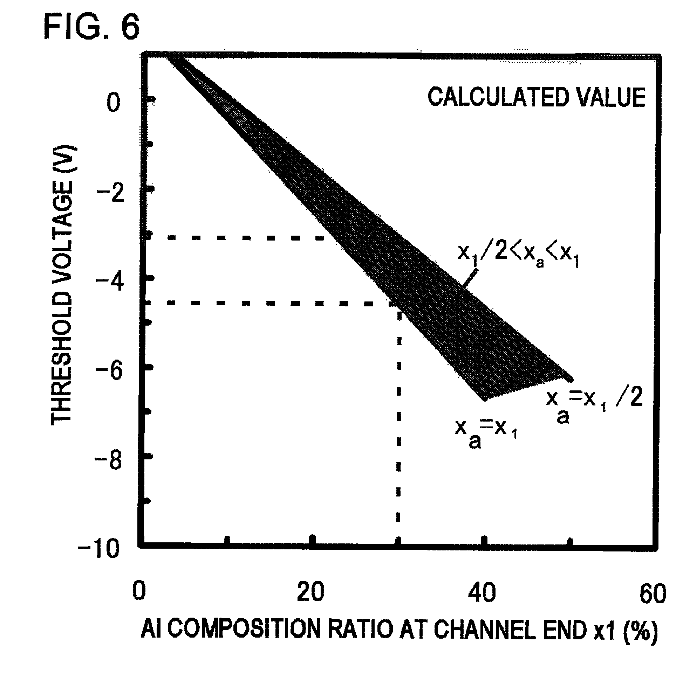

Last, dependent properties of Al composition ratios of threshold voltages $V_{th}$ are calculated. Fig. 6 is dependent properties of Al composition ratios at the channel end $x_1$ of a calculated $V_{th}$. From the view point of preventing a decrease in mutual conductance and an increase in drain conductance, $V_{th}$ needs to be larger than -5 V. In Fig. 6, regions which satisfy Equation 4 and Equation 5 at the same time are regions surrounded by a condition ($x_a=x_1$) and a condition ($x_a=x_1/2$) (shown by inclined lines in Fig. 6) and on a straight line of $x_a=x_1/2$.

It turns out from Fig. 6 that, if Equation 4 and Equation 5 are satisfied and it is set to

$$x_1 \leq 0.3 \qquad (Equation\ 3),$$

$V_{th}$ is larger than -5 V. $V_{th}$ equal to or less than -5 V causes a considerable decrease in mutual conductance and a considerable increase in drain conductance; and therefore, Equation 3 is set as an upper limit of the Al composition ratio $x_1$.

In addition, in the case of $x_1>0.3$, a critical film thickness for dislocation generation becomes very small (specifically, approximately equal to or less than 25 nm), and it becomes difficult to make a crystal of good heterojunction.

From the above discussion, in the case where the Al composition ratios ($x_1$ and $x_a$) satisfy
$x_1/2 \leq x_a < x_1$ and
$x_1 \leq 0.3$,
it is shown that a gate current suppression effect can be obtained and $I_{max}$ and $V_{th}$ are within a desired range.

Next, implemental examples of the present invention will be described in detail.

(First Implemental Example)

Fig. 1 is a view showing a cross sectional structure of one example of an HJFET 1 of the present invention. Such HJFET 1 is manufactured by the following manner.

Layers to be described below are sequentially grown on a (0001) SiC substrate 10 by a metalorganic chemical vapor deposition (abbreviated as MOCVD) method, for example.

Buffer layer 11 (undoped AlN layer): 20 nm
Channel layer 12 (undoped GaN layer): 2 $\mu$m
Electron supply layer 13 (undoped gradient composition $Al_xGa_{1-x}N$ ($0<x<1$)): t=25 nm

The Al composition ratios x of the electron supply layer 13 are continuously decreased from an interface ($x=x_1$) with the channel layer 12 toward a surface (interface ($x=x_2$) with a gate electrode 17). In the present implemental example, a gate interface 13A is the surface of the electron supply layer 13; and therefore, the Al composition ratio $x_a$ (Al composition ratio at the gate end $x_a$) at the interface between the electron supply layer 13 and the gate electrode 17 coincides with the Al composition ratio $x_2$. That is, it is set to $x_a=x_2$, and
$x_1/2 \leq x_a < x_1$ and
$x_1 \leq 0.3$
ara satisfied.

More specifically, it is set to $x_1=0.20$ and $x_2=0.15$.

In addition, AlGaN and GaN are different in lattice constant; however, a film thickness of 25 nm of the electron supply layer 13 is equal to or less than a critical film thickness for dislocation generation.

Furthermore, in the case where the electron supply layer 13 is formed, the supply amount of trimethylgallium (TMG), trimethylaluminum (TMA), and ammonia ($NH_3$) gas from a gas introduction pipe of a metalorganic chemical vapour deposition (MOCVD) apparatus is adjusted; the supply amount of trimethylaluminum (TMA) and ammonia ($NH_3$) is kept constant; and the supply amount of trimethylgallium (TMG) is gradually increased.

Next, a metal such as Ti/Al/Nb/Au is deposited on the electron supply layer 13 and an alloy process is performed; and accordingly, a source electrode 15S and a drain electrode 15D are formed, respectively. Ohmic contacts are formed between the source electrode 15S and the electron supply layer 13, and between the drain electrode 15D and the electron supply layer 13.

Next, a metal such as Ni/Au is deposited at a portion sandwiched between the source electrode 15S and the drain electrode 15D on the surface of the electron supply layer 13, and liftoff process is performed; and accordingly, a gate electrode 17 is formed. In this manner, a Schottky contact is formed at the interface 13A with the electron supply layer 13.

Last, for example, an SiN film (dielectric film) 18 is grown, for example, by approximately 100 nm using a plasma-enhanced chemical vapor deposition (abbreviated as PECVD) method.

In this manner, the HJFET 1 as shown in Fig. 1 is manufactured. In such the HJFET 1, a gate current suppression effect can be obtained, and $I_{max}$ and $V_{th}$ are within a desired range. More specifically, in the case where the Al composition ratios are set to $x_1=0.2$ and $x_a=0.15$, a gate leak current is suppressed to approximately 2% of the related art ($x_1=x_a=0.2$). Furthermore, as compared with the related art, a decrease width of $I_{max}$ becomes approximately 25% and $V_{th}$ becomes approximately -2.0 V.

(Second Implemental Example)

In the first implemental example, the Al composition ratios are continuously changed in the electron supply layer 13. Therefore, there are problems in that raw material gas flow rate needs to be accurately controlled, epitaxial growth is difficult, and reproducibility is lowered.

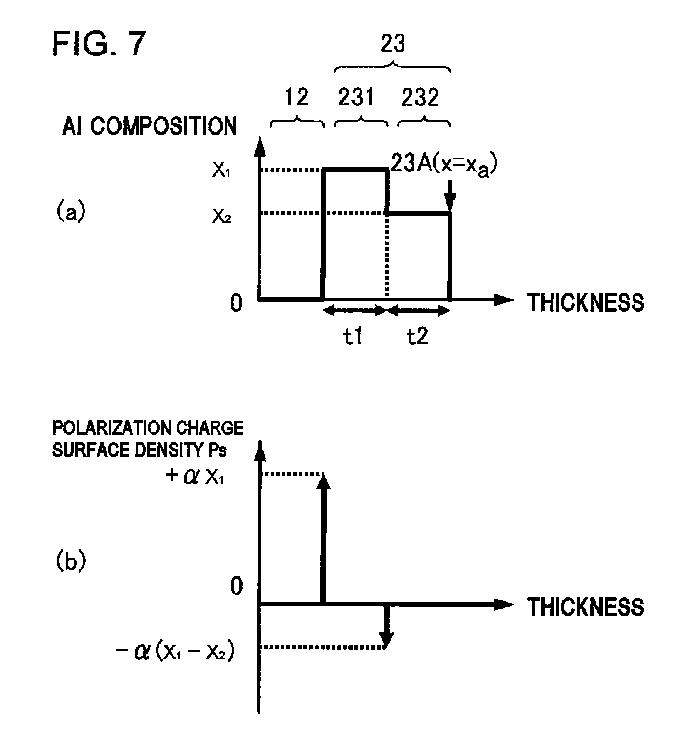

The present implemental example solves this problem. A second implemental example according to the present invention is one in which, in the first implemental example shown in Fig. 1, the electron supply layer 13 is replaced with an electron supply layer 23 whose Al compositions are decreased in a stepwise fashion (see Fig. 7(a)).

The electron supply layer 23 ($Al_xGa_{1-x}N$ (0<x<1)) whose Al compositions are decreased in a stepwise fashion has an undoped $Al_{x1}Ga_{1-x1}N$ layer 231 which is formed on a channel layer 12 and an undoped $Al_{x2}Ga_{1-x2}N$ layer 232 which is formed on the undoped $Al_{x1}Ga_{1-x1}N$ layer 231.

Composition $x_1$ of the undoped $Al_{x1}Ga_{1-x1}N$ layer 231 and a composition $x_2$ of the undoped $Al_{x2}Ga_{1-x2}N$ are constant; and it is set to $x_1>x_2$ ($0<x_1<1$ and $0<x_2<1$). In this case, the compositions are constant means that a variation of approximately 0.005 may be included with respect to the compositions $x_1$ and $x_2$.

Al composition ratios in the electron supply layer 23 are decreased in a stepwise fashion from a channel interface ($x=x_1$) toward a surface ($x=x_2$). In the present implemental example, a gate interface 23A is the surface of the electron supply layer 23; and therefore, an Al composition ratio at the gate end ($x_a$) coincides with an Al composition ratio $x_2$ at the surface of the electron supply layer 23. That is, it is set to $x_a=x_2$, and the Al composition ratios ($x_1$ and $x_a$) satisfy $x_1/2 \leq x_a < x_1$ and $x_1 \leq 0.3$.

More specifically, it is set to $x_1=0.20$ and $x_2=0.15$, and each film thickness of the undoped $Al_{x1}Ga_{1-x1}N$ layer 231 and the undoped $Al_{x2}Ga_{1-x2}N$ layer 232 is 12 nm.

AlGaN and GaN are different in lattice constant; however, a total film thickness 24 nm of the electron supply layer 23 is equal to or less than a critical film thickness for dislocation generation.

Fig. 7(a) shows a view showing the distribution of the Al composition ratios in a direction perpendicular to a substrate in an HJFET of the second implemental example, Fig. 7(b) is a typical view of the distribution of polarization charge surface densities of the second implemental example.

The Al composition ratios of the electron supply layer 23 are decreased in a stepwise fashion from the channel interface ($x_1$) toward the gate interface ($x_a=x_2$). According to Equation 1, a positive polarization charge whose surface density (Ps) is expressed as a below equation is generated at the interface between the channel layer 12 and the electron supply layer 23.

$Ps=+\alpha x_1$

Furthermore, according to Equation 1, a negative polarization charge whose surface density (Ps) is expressed as a below equation is generated at an interface between the undoped $Al_{x1}Ga_{1-x1}N$ layer 231 and the undoped $Al_{x2}Ga_{1-x2}N$ layer 232.

$$Ps = -\alpha(x_1-x_2)$$

As described above, the negative polarization charge is generated; and accordingly, a gate current suppression effect can be obtained.

Further, $x_1/2 \leq x_a < x_1$ and $x_1 \leq 0.3$ are satisfied; and accordingly, $I_{max}$ and $V_{th}$ are within a desired range. More specifically, in the case where the Al composition ratios are set to $x_1=0.20$ and $x_a=0.15$, a gate leak current is suppressed to approximately 2% of the related art ($x_1=x_a=0.2$). Furthermore, as compared with the related art, a decrease width of $I_{max}$ is approximately 25% and $V_{th}$ is approximately -2.0 V.

Further, the present implemental example uses the structure whose compositions are decreased in a stepwise fashion; and therefore, growth can be achieved using an epitaxial growth technique just similarly to the HJFET according to the related art, and reproducibility of a device characteristic is improved as compared with the case where a gradient composition AlGaN structure like the first implemental example is used.

In addition, in the present implemental example, the electron supply layer 23 is a two-layer structure; as a matter of course, it may be configured by a layer structure with as least three layers.

(Third Implemental Example)

The first implemental example adopts a planar structure; and therefore, there are problems in that influence of a surface trap becomes prominent, and various characteristics such as a gate breakdown voltage and a current collapse are easy to fluctuate depending on an element surface state. The present implemental example improves this problem.

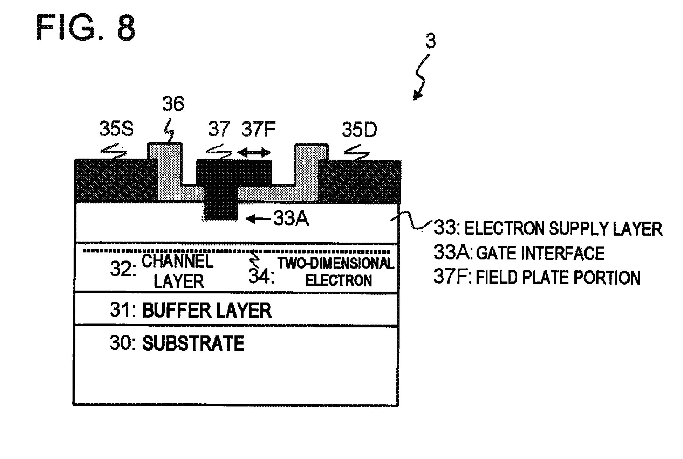

Fig. 8 is a view showing a cross sectional structure of an HJFET 3 of the present implemental example.

The HJFET 3 has an SiC substrate 30; an undoped AlN buffer layer 31 formed on the substrate 30; a channel layer 32 made of $In_yGa_{1-y}N$ ($0 \leq y \leq 1$) (in this case, made of undoped GaN) which is formed on the buffer layer 31; an electron supply layer 33 made of $Al_xGa_{1-x}N$ ($0 < x < 1$) which is formed on the channel layer 32; and a source electrode 35S, a drain electrode 35D, a gate electrode 37, and an SiN film (dielectric film) 36, those of which are formed on the electron supply layer 33.

With piezo polarization effects and spontaneous polarization effects, both being caused by a lattice constant difference between GaN of the channel layer 32 and AlGaN of the electron supply layer 33, a two-dimensional electron gas 34 is formed in the vicinity of an interface between the channel layer 32 and the electron supply layer 33.

In the electron supply layer 33, compositions x are gradually decreased from the side of the interface between the electron supply layer 33 and the channel layer 32 toward upward direction. An Al composition $x_2$ of a surface of the electron supply layer 33 is smaller than an Al composition ratio $x_1$ at the interface between the electron supply layer 33 and the channel layer 32.

Further, a concave recess portion is formed in the electron supply layer 33, and the gate electrode 37 is formed so as to embed the recess portion. Schottky contact with the electron supply layer 33 is formed at an interface 33A between the electron supply layer 33 and the gate electrode 37.

In the electron supply layer 33, the Al composition ratio $x_1$ at the interface between the electron supply layer 33 and the channel layer 32 and an Al composition ratio $x_a$ at the interface 33A (bottom face of the recess portion) between the electron supply layer 33 and the gate electrode 37 satisfy

$x_1/2 \leq x_a < x_1$ and

$x_1 \leq 0.3$.

More specifically, it is set to $x_1=0.2$, $x_a=0.175$, and $x_2=0.15$; or $x_1=0.2$, $x_a=0.15$, and $x_2=0.1$.

In this case, the gate electrode 37 has a field plate portion 37F extended in a peaked shape toward the drain electrode 35D side, and the field plate portion 37F is located at an upper portion of the SiN film 36.

The SiN film 36 is formed on the electron supply layer 33. Furthermore, the source electrode 35S and the drain electrode 35D are formed on the electron supply layer 33, and ohmic contacts are formed.

The thus configured HJFET 3 is manufactured by the following process.

An undoped AlN buffer layer 31 of 20 nm, a channel layer 32 of 2 $\mu$m, and an electron supply layer 33 of 40 nm are stacked on a (0001) SiC substrate 30 by an MOCVD method, for example. AlGaN and GaN are different in lattice constant; however, a film thickness of 40 nm of the electron supply layer 33 is equal to or less than a critical film thickness for dislocation generation.

In the electron supply layer 33, it is set to $x_1 > x_2$. Furthermore, in the case where the electron supply layer 33 is formed, the supply amount of trimethylgallium (TMG), trimethylaluminum (TMA), and ammonia ($NH_3$) gas from a gas introduction pipe of a metalorganic chemical vapour deposition (MOCVD) apparatus is adjusted; the supply amount of trimethylaluminum (TMA) and ammonia ($NH_3$) are kept constant; and the supply amount of trimethylgallium (TMG) is gradually increased.

A metal such as Ti/Al/Nb/Au is deposited on the electron supply layer 33 and an alloy process is performed; and accordingly, a source electrode 35S and a drain electrode 35D are formed, respectively; and ohmic contacts are formed.

Next, an SiN film 36 is grown by approximately 100 nm using a PECVD method, for example. An opening portion is formed at a portion sandwiched between the source electrode 35S and the drain electrode 35D on the surface of the electron supply layer 33 by removing by etching the SiN film 36. Next, a recess portion is formed by selectively removing by etching a part of the electron supply layer 33 using a dry etching apparatus which uses a shlorine-based gas, for example. A metal such as Ni/Au is deposited on the recess portion and liftoff process is performed; and accordingly, a gate electrode 37 having a field plate portion 37F is formed. In this manner, a Schottky contact is formed at an interface 33A with the AlGaN layer. In such a manner, the HJFET 3 shown in Fig. 8 is manufactured.

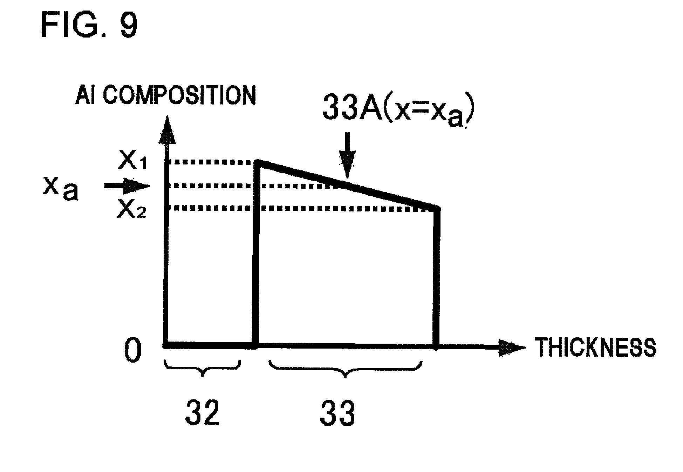

Fig. 9 is a typical view of the distribution of the Al composition ratios in a direction perpendicular to the substrate in the present implemental example. In the present implemental example, the Al composition ratios x of the electron supply layer 33 are continuously decreased from a channel interface toward a gate interface, and are further decreased toward the surface of the electron supply layer 33. The gate electrode 37 is formed at the recess portion where a part of the electron supply layer 33 is removed by etching; and therefore, the Al composition ratio $x_a$ at the gate interface 33A satisfies $x_2 < x_a < x_1$. The distribution of polarization charge densities of the present implemental example are the same as that shown in Fig. 2 (b).

In the present implemental example, the gate electrode 37 is formed at the recess portion where a part of the electron supply layer 33 is removed by etching. Therefore, a distance between the two-dimensional electron gas 34 and the surface of the electron supply layer 33 can be increased with a distance between the two-dimensional electron gas 34 and the gate electrode 37 being reduced and with a mutual conductance being highly maintained; and consequently, instability aspect like a current collapse caused by a surface trap can be suppressed.

Further, the gate electrode 37 has the field plate portion 37F being in contact with the SiN film 36. A depletion layer is formed under the field plate portion 37F, electric field strength between the gate and the drain is reduced, and a gate breakdown voltage is improved.

In addition, in the present implemental example, the electron supply layer 33 is configured such that the Al composition ratios are continuously decreased; however, the present implemental example is not limited to this, and there may be adopted a configuration in which the Al compositions are decreased in a stepwise fashion.

Now, in order to confirm the effect of the present implemental example, HJFETs with the following three types of recess structures are manufactured and compared.

Structure 1: $x_1=x_a=x_2=0.2$ (related art)

Structure 2: $x_1=0.2$, $x_a=0.175$, $x_2=0.15$ (implemental example of the present invention)

Structure 3: $x_1=0.2$, $x_a=0.15$, $x_2=0.1$ (implemental example of the present invention)

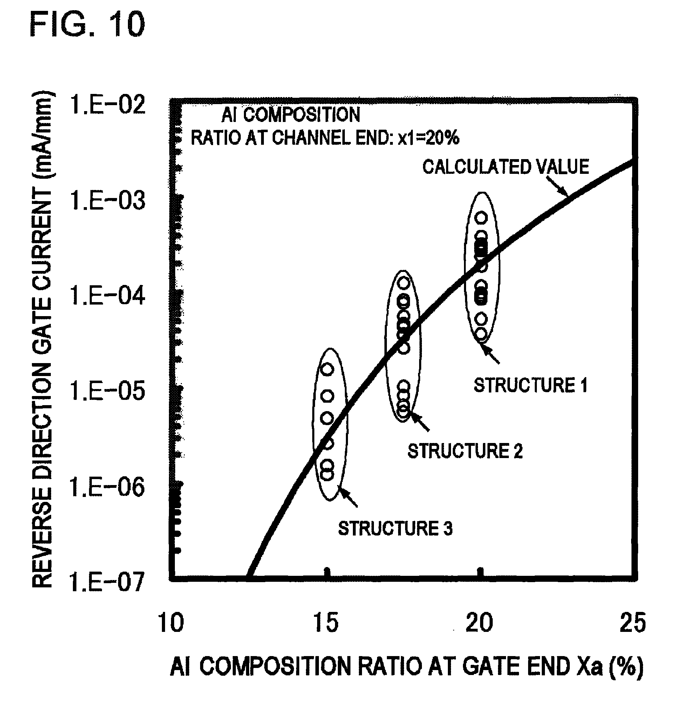

Structure 1 corresponds to the HJFET with the recess structure in which the Al composition ratio is uniform (related art). Fig. 10 is dependent properties of Al composition ratios at the gate end $x_a$ of gate leak currents measured in the HJFETs. As compared with Structure 1 (related art), the gate leak currents of Structure 2 and Structure 3 are considerably suppressed to approximately 17% and approximately 2%, respectively. Calculated values are also shown in the drawing. The measured gate current values are in good agreement with calculated results. The measurement show results of 16 points in a 2 inch wafer face. Variation in gate current is mainly caused by variation in thickness of the electron supply layer.

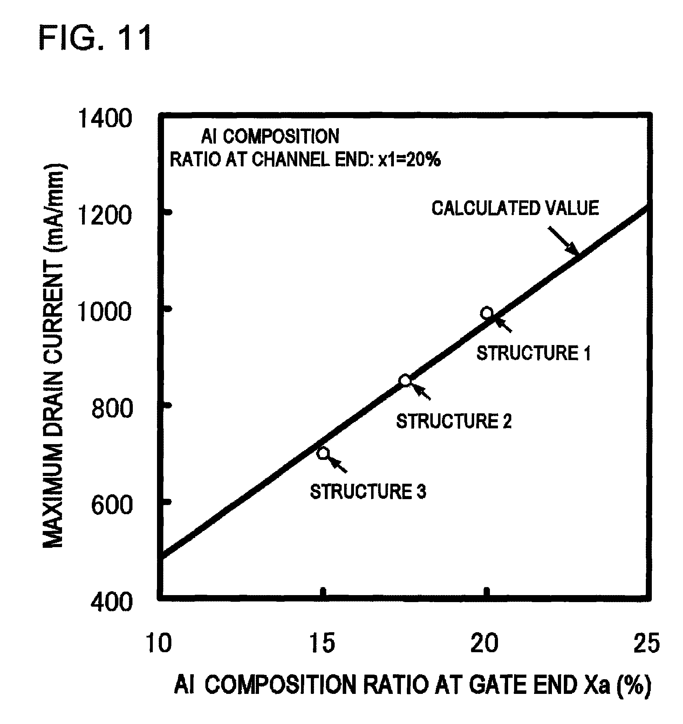

Fig. 11 is dependent properties of Al composition ratios at the gate end $x_a$ of $I_{max}$ measured in the three types of the HJFETs. As compared with Structure 1 (related art), respective decrease widths of $I_{max}$ of Structure 2 and Structure 3 are approximately 13% and approximately 25%, both of which being with in a set range. Measured values are also shown in the drawing. The measured $I_{max}$ values are in good agreement with calculated results.

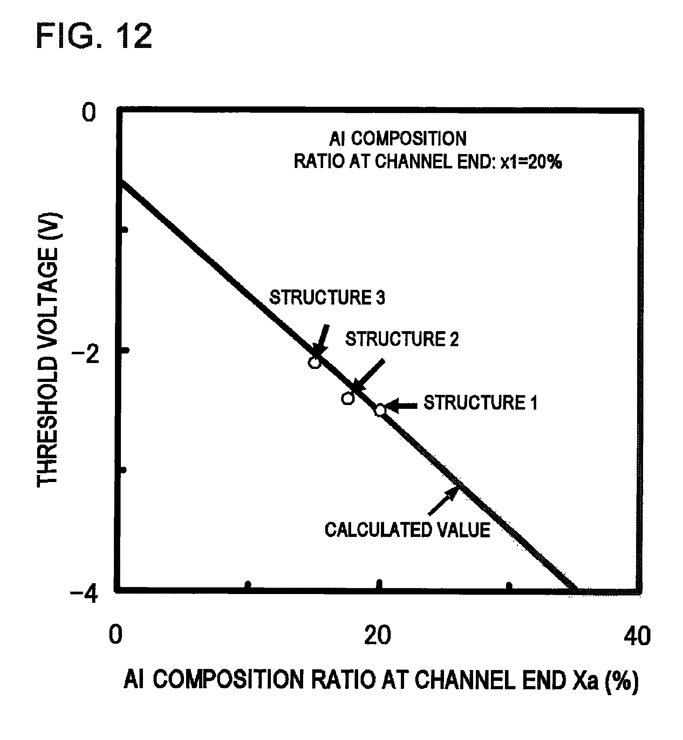

Fig. 12 is dependent properties of Al composition ratios at the gate end $x_a$ of $V_{th}$ measured in the three types of the HJFETs. In each of the structures, $V_{th}$ is larger than -5 V, and is within a set range. Measured values are also shown in the drawing. The measured $V_{th}$ values are in good agreement with calculated results.

(Fourth Implemental Example)

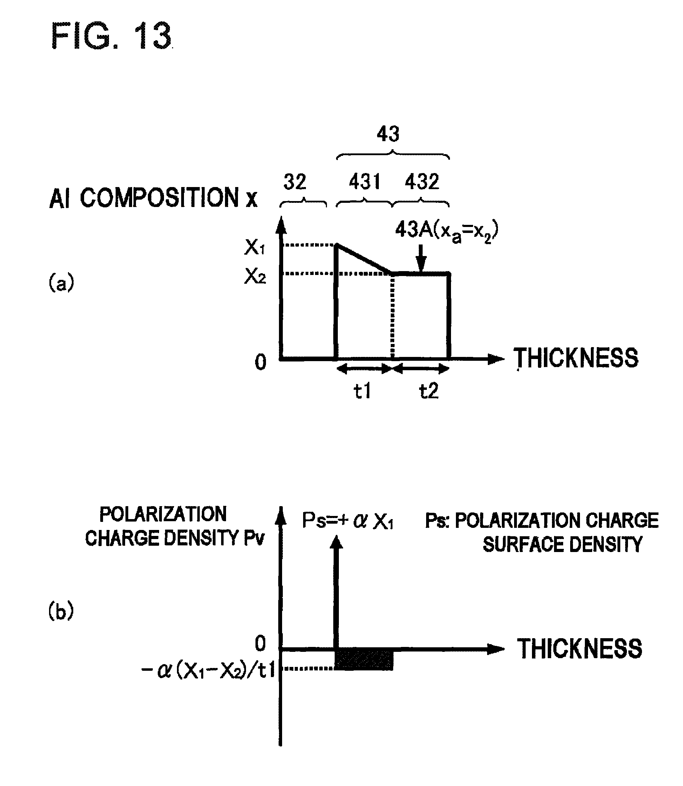

In the third implemental example, since the recess structure is adopted, the influence of the surface trap can be suppressed. On the contrary, there is a problem in that uniformity in wafer face of element characteristics such as a gate current deteriorates because the Al composition ratio at the gate end $x_a$ is also changed with a change in depth of recess etching. The present implemental example solves this problem. In a fourth implemental example according to the present invention, the electron supply layer 33 shown in Fig. 8 in the third implemental example is replaced with an electron supply layer 43 as shown in Fig. 13(a).

The electron supply layer 43 ($Al_xGa_{1-x}N$ (0<x<1)) has an undoped gradient composition $Al_dGa_{1-d}N$ layer (first electron supply layer) 431 and an undoped $Al_{x2}Ga_{1-x2}N$ layer (second electron supply layer) 432 formed on the undoped gradient composition $Al_dGa_{1-d}N$ layer 431 (0<d<1 and 0<$x_2$<1).

The undoped gradient composition $Al_dGa_{1-d}N$ layer 431 is a layer whose compositions d are continuously decreased from the side of a channel layer 32 toward the undoped $Al_{x2}Ga_{1-x2}N$ layer 432 side.

In this case, the Al composition d at an interface between the undoped gradient composition $Al_dGa_{1-d}N$ layer 431 and the channel layer 32 is $x_1$, and it is set to $x_1>x_2$. More specifically, it is set to $x_1=0.20$ and $x_2=0.15$. Furthermore, each thickness of the undoped gradient composition $Al_dGa_{1-d}N$ layer 431 and the undoped $Al_{x2}Ga_{1-x2}N$ layer 432 is 20 nm. AlGaN and GaN are different in lattice constant; however, a total film thickness of 40 nm of the electron supply layer 43 is equal to or less than a critical film thickness for dislocation generation. The undoped $Al_{x2}Ga_{1-x2}N$ layer 432 is a layer whose composition $x_2$ is constant.

Fig. 13(b) is a typical view of the distribution of polarization charge densities in a direction perpendicular to a substrate in the present implemental example.

In the present implemental example, a gate electrode 37 is formed at a recess portion where a part of the undoped $Al_{x2}Ga_{1-x2}N$ layer 432 is removed by etching; and therefore, an Al composition ratio $x_a$ at a gate interface 43A is equal to the Al composition ratio $x_2$ of the undoped $Al_{x2}Ga_{1-x2}N$ layer 432.

Furthermore, the Al composition ratio $x_1$ at an interface between the electron supply layer 43 and the channel layer 32 and the Al composition ratio $x_a$ at an interface between the electron supply layer 43 and the gate electrode 37 satisfy

$x_1/2 \leq x_a < x_1$ and
$x_1 \leq 0.3$.

According to Equation 1, a positive polarization charge whose surface density (Ps) is expressed as a below equation is generated at an interface between the channel layer 32 and the undoped gradient composition $Al_dGa_{1-d}N$ layer 431.

$$Ps = +\alpha x_1$$

Futhermore, a negative polarization charge whose volume density (Pv) is expressed as a below equation is generated in the undoped gradient composition $Al_dGa_{1-d}N$ layer 431.

$$Pv = -\alpha(x_1 - x_2)/t1$$

In such an HJFET of the present implemental example, a gate current suppression effect can be obtained.

Further, $x_1/2 \leq x_a < x_1$ and $x_1 \leq 0.3$ are satisfied; and accordingly, $I_{max}$ and $V_{th}$ are within a desired range.

More specifically, in the case where the Al composition ratios are set to $x_1 = 0.20$ and $x_a = 0.15$, a gate leak current is suppressed to approximately 2% of the related art ($x_1 = x_a = 0.2$). Furthermore, as compared with the related art, a decrease width of $I_{max}$ is approximately 25%, and $V_{th}$ is approximately -2.0 V.

Furthermore, in the present implemental example, the Al composition ratio is constant in the undoped $Al_{x2}Ga_{1-x2}N$ layer 432; and therefore, the Al composition ratio at the gate end $x_a$ is not changed even where a recess depth is slightly fluctuated. Therefore, the HJFET can be excellent in manufacturing stability.

In addition, in the present implemental example, the undoped gradient composition $Al_dGa_{1-d}N$ layer 431 is configured by a layer whose compositions d are continuously decreased; as a matter of course, it may be configured by an AlGaN layer whose compositions are decreased in a stepwise fashion or by an AlGaN layer ($d = x_1$) of a single layer.

(Fifth Implemental Example)

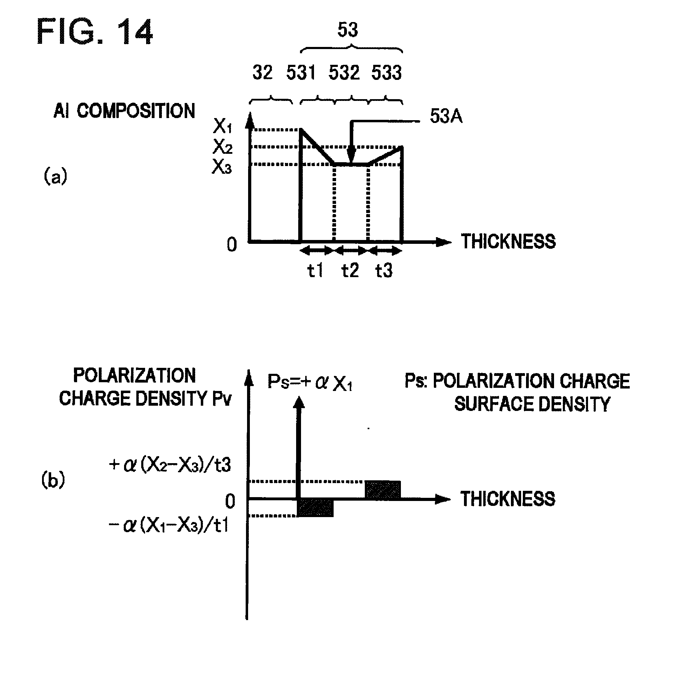

In the fourth implemental example, the negative polarization charge is generated in the undoped gradient composition $Al_dGa_{1-d}N$ layer 431 and the gate current is reduced; on the contrary, there is a problem in that the negative polarization charge is also generated under ohmic electrodes (35S and 35D) and ohmic contact resistance is increased. The present implemental example solves this problem. In a fifth implemental example according to the present invention, the electron supply layer 33 shown in Fig. 8 in the third implemental example is replaced with an electron supply layer 53 ($Al_xGa_{1-x}N$ ($0 < x < 1$), see Fig. 14(a)).

The electron supply layer 53 has an undoped gradient composition $Al_EGa_{1-E}N$ layer (first electron supply layer) 531, an undoped $Al_{x3}Ga_{1-x3}N$ layer (second electron supply layer) 532 formed on the undoped gradient composition $Al_EGa_{1-E}N$ layer 531, and an undoped gradient composition $Al_FGa_{1-F}N$ layer (third electron supply layer) 533 formed on the undoped $Al_{x3}Ga_{1-x3}N$ layer 532.

Composition ratios E of the undoped gradient composition $Al_EGa_{1-E}N$ layer 531 are continuously decreased from the side of a channel layer 32 toward the undoped $Al_{x3}Ga_{1-x3}N$ layer 532 side. More specifically, the composition ratios E are decreased from $x_1$ toward $x_3$. A composition ratio at an interface between the undoped gradient composition $Al_EGa_{1-E}N$ layer 531 and the channel layer 32 is $x_1$.

In the undoped $Al_{x3}Ga_{1-x3}N$ layer 532, an Al composition ratio is $x_3$ and constant (for example, $x_3 = 0.15$).

In the undoped gradient composition $Al_FGa_{1-F}N$ layer 533, composition ratios F are continuously increased from the undoped $Al_{x3}Ga_{1-x3}N$ layer 532 side toward the surface side. The composition ratio F at the surface of the undoped gradient composition $Al_FGa_{1-F}N$ layer 533 is $x_2$.

It is set to $0 < E < 1$, $0 < x_3 < 1$, and $0 < F < 1$, where it is set to $x_1 > x_3$ and $x_2 > x_3$. More specifically, it is set to $x_1 = 0.2$, $x_2 = 0.175$, and $x_3 = 0.15$; and each thickness of the respective layers 531 to 533 is 15 nm. AlGaN and GaN are different in lattice constant; however, a total film thickness of 45 nm of the electron supply layer 53 is equal to or less than a critical film thickness for dislocation generation.

In the present implemental example, the gate electrode 37 is formed at a recess potion where parts of the undoped gradient composition $Al_FGa_{1-F}N$ layer 533 and the undoped $Al_{x3}Ga_{1-x3}N$ layer 532 are removed by etching; and therefore, an Al composition ratio $x_a$ at a gate interface 53A is equal to the Al composition ratio $x_3$ of the undoped $Al_{x3}Ga_{1-x3}N$ layer 532.

Further, Al composition ratios ($x_1$ and $x_a$) satisfy $x_1/2 \leq x_a < x_1$ and
$x_1 \leq 0.3$.

Fig. 14 (b) shows the distribution of a polarization charge in a direction perpendicular to a substrate in the present implemental example.

According to Equation 1, a positive polarization charge whose surface density (Ps) is expressed as a below equation is generated at an interface between the channel layer 32 and the undoped gradient composition $Al_EGa_{1-E}N$ layer 531.

$$Ps = +\alpha x_1$$

A negative polarization charge whose volume density (Pv) is expressed as a below equation is generated in the undoped gradient composition $Al_EGa_{1-E}N$ layer 531.

$$Pv = -\alpha(x_1 - x_3)/t1$$

Furthermore, a positive polarization charge whose volume density (Pv) is expressed as a below equation is generated in the undoped gradient composition $Al_FGa_{1-F}N$ layer 533.

$$Pv = +\alpha(x_2 - x_3)/t3$$

In such an HJFET, a gate current suppression effect can be obtained and $I_{max}$ and $V_{th}$ are within a desired range. More specifically, in the case where the Al composition ratios are set to $x_1 = 0.20$ and $x_a = 0.15$, a gate leak current is suppressed to approximately 2% of the related art ($x_1 = x_a = 0.2$). Furthermore, as compared with the related art, a decrease width of $I_{max}$ is approximately 25%, and $V_{th}$ is approximately -2.0 V.

Furthermore, in the present implemental example, the Al composition ratio is constant in the undoped $Al_{x3}Ga_{1-x3}N$ layer 532; and therefore, the Al composition ratio at the gate end $x_a$ is not changed even where a recess depth is slightly fluctuated. This can improve manufacturing stability of the HJFET.

Further, in the present implemental example, a positive polarization charge is generated in the undoped gradient composition $Al_FGa_{1-F}N$ layer 533 located under the ohmic electrodes (35S and 35D). Therefore, the negative polarization charge in the undoped gradient composition $Al_EGa_{1-E}N$ layer 531 is negated, a depletion layer is not generated under the ohmic electrodes, and an increase in ohmic contact resistance is suppressed.

In addition, in the present implemental example, the undoped gradient composition $Al_EGa_{1-E}N$ layer 531 is configured such that the compositions are continuously decreased; however, it may be a layer whose compositions are changed in a stepwise fashion, or it may be a layer whose compositions are not changed ($E = x_1$). Similarly, in the present implemental example, the undoped gradient composition $Al_FGa_{1-F}N$ layer 533 is configured such that the compositions are continuously increased; however, the present implemental example is not limited to this, and it may be a layer whose compositions are increased in a stepwise fashion, or it may be a layer whose compositions are uniform ($F = x_3$).

(Sixth Implemental Example)

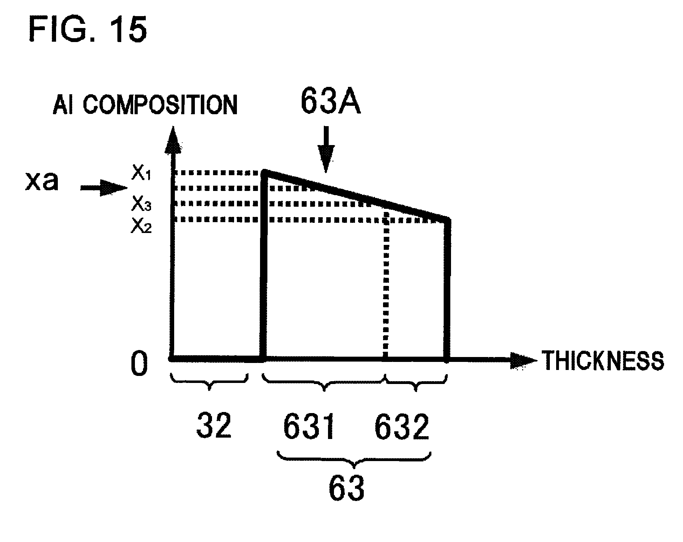

In the third implemental example, the negative polarization charge is generated in the electron supply layer 33 and the gate current is reduced; on the contrary, there is a problem in that the negative polarization charge is also generated under ohmic electrodes (35S and 35D) and ohmic contact resistance is increased. The present implemental example solves this problem. In a sixth implemental example according to the present invention, the electron supply layer 33 shown in Fig. 8 in the third implemental example is replaced with an electron supply layer 63 ($Al_xGa_{1-x}N$ ($0 < x < 1$)) as shown in Fig. 15.

As shown is Fig. 15, the electron supply layer 63 has an undoped gradient composition $Al_gGa_{1-g}N$ layer 631 (($0 < g < 1$)) and an n-type gradient composition $Al_hGa_{1-h}N$ layer 632 ($0 < h < 1$) formed on the undoped gradient composition $Al_gGa_{1-g}N$ layer 631. A source electrode 35S and a drain electrode 35D are formed in contact with this layer on the n-type gradient composition $Al_hGa_{1-h}N$ layer 632. As described above, in the present implemental example, an uppermost layer of the electron supply layer 63 being in contact with the source electrode 35S and the drain electrode 35D has n-type AlGaN.

In the undoped gradient composition $Al_gGa_{1-g}N$ layer 631, compositions are continuously decreased toward the n-type gradient composition $Al_hGa_{1-h}N$ layer 632. The composition at an interface between the undoped gradient

composition $Al_gGa_{1-g}N$ layer 631 and a channel layer 32 is $x_1$, and the composition at an interface between the undoped gradient composition $Al_gGa_{1-g}N$ layer 631 and the n-type gradient composition $Al_hGa_{1-h}N$ layer 632 is $x_3$.

In the n-type gradient composition $Al_hGa_{1-h}N$ layer 632, the compositions are continuously decreased from the interface with the undoped gradient composition $Al_gGa_{1-g}N$ layer 631 toward a surface. More specifically, the compositions are decreased from $x_3$ to $x_2$. In addition, it is set to $x_1 > x_3 > x_2$.

More specifically, it is set to $x_1 = 0.25$, $x_2 = 0.05$, and $x_3 = 0.12$.

Furthermore, a thickness of the undoped gradient composition $Al_gGa_{1-g}N$ layer 631 is $t_1 = 30$ nm, and a thickness of the n-type gradient composition $Al_hGa_{1-h}N$ layer 632 is $t_2 = 15$ nm. AlGaN and GaN are different in lattice constant; however, a total film thickness of 45 nm of the electron supply layer 63 is equal to or less than a critical film thickness for dislocation generation. Furthermore, an n-type impurity of the n-type gradient composition $Al_hGa_{1-h}N$ layer 632 is, for example, silicon (Si); and its impurity concentration is, for example, $7.5 \times 10^{18}$ cm$^{-3}$.

The gate electrode 37 is formed at a recess portion where parts of the n-type gradient composition $Al_hGa_{1-h}N$ layer 632 and the undoped gradient composition $Al_gGa_{1-g}N$ layer 631 are removed by etching; and therefore, an Al composition ratio $x_a$ at a gate interface 63A satisfies $x_3 < x_a < x_1$.

Further,

$x_1/2 \leq x_a < x_1$ and
$x_1 \leq 0.3$
are satisfied.

More specifically, it is set to $x_1 = 0.25$ and $x_a = 0.15$. The distribution of polarization charge densities in the present implemental example are the same as that shown in Fig. 2(b).

In such an HJFET, a gate current suppression effect can be obtained; and $I_{max}$ and $V_{th}$ are within a desired range. As one example, in the case where the Al composition ratios are set to $x_1 = 0.25$ and $x_a = 0.15$, a gate leak current is suppressed to approximately 0.1% of the related art ($x_1 = x_a = 0.25$). Furthermore, as compared with the related art, a decrease width of $I_{max}$ is approximately 40% and $V_{th}$ is approximately -2.6 V.

Furthermore, in the present implemental example, a positive ionized impurity charge is generated in the n-type gradient composition $Al_hGa_{1-h}N$ layer 632 located under the ohmic electrodes (35S and 35D). Therefore, the negative polarization charge in the undoped gradient composition $Al_gGa_{1-g}N$ layer 631 is negated, a depletion layer is not generated under the ohmic electrodes, and an increase in ohmic contact resistance is suppressed.

In addition, in the present implemental example, the undoped gradient composition $Al_gGa_{1-g}N$ layer 631 and the n-type gradient composition $Al_hGa_{1-h}N$ layer 632 are configured such that the compositions are continuously decreased; however, it may be a structure in which the compositions are decreased in a stepwise fashion.

(Seventh Implemental Example)

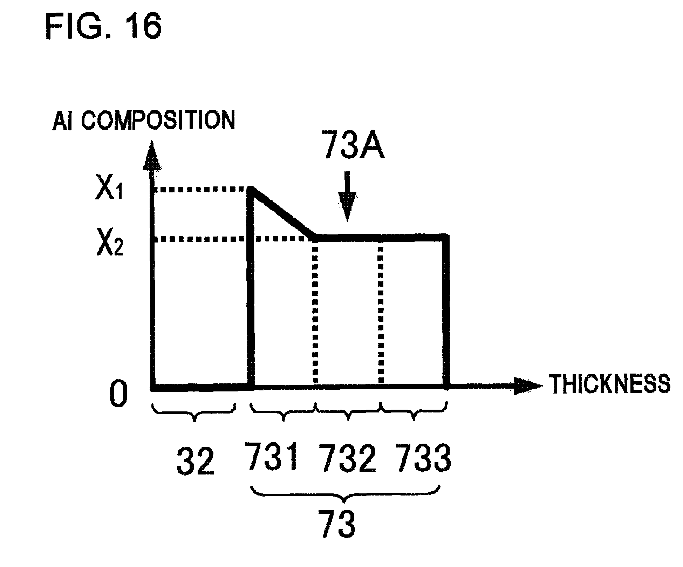

In the fourth implemental example, the negative polarization charge is generated in the undoped gradient composition $Al_dGa_{1-d}N$ layer 431 and the gate current is reduced; on the contrary, there is a problem in that the negative polarization charge is also generated under ohmic electrodes (35S and 35D) and ohmic contact resistance is increased. The present implemental example solves this problem. In a seventh implemental example according to the present invention, the electron supply layer 33 shown in Fig. 8 in the third implemental example is replaced with an electron supply layer ($Al_xGa_{1-x}N$ ($0 < x < 1$)) 73 shown in Fig. 16.

The electron supply layer 73 has an undoped gradient composition $Al_jGa_{1-j}N$ layer ($0 < j < 1$) 731, an undoped $Al_{x2}Ga_{1-x2}N$ layer 732 formed on the undoped gradient composition $Al_jGa_{1-j}N$ layer 731, and an n-type $Al_{x2}Ga_{1-x2}N$ layer 733 formed on the undoped $Al_{x2}Ga_{1-x2}N$ layer 732 ($0 < x_2 < 1$).

In the undoped gradient composition $Al_jGa_{1-j}N$ layer ($0 < j < 1$) 731, compositions are continuously decreased from the side of an interface with a channel layer 32 toward the undoped $Al_{x2}Ga_{1-x2}N$ layer 732 side, and the compositions are decreased from $x_1$ to $x_2$.

The composition at the interface between the undoped gradient composition $Al_jGa_{1-j}N$ layer ($0 < j < 1$) 731 and the channel layer 32 is $x_1$, and it is set to $x_1 > x_2$.

In the undoped $Al_{x2}Ga_{1-x2}N$ layer 732 and the n-type $Al_{x2}Ga_{1-x2}N$ layer 733, the Al compositions are $x_2$ and constant.

More specifically, it is set to $x_1 = 0.25$ and $x_2 = 0.15$, and each film thickness of the respective layers 731 to 733 is 15 nm. AlGaN and GaN are different in lattice constant; however, a total film thickness of 45 nm of the electron supply layer 73 is equal to or less than a critical film thickness for dislocation generation. Furthermore, an n-type impurity of the n-type $Al_{x2}Ga_{1-x2}N$ layer 733 is, for example, Si; and its impurity concentration is $3.7 \times 10^{18}$ cm$^{-3}$.

In the present implemental example, the gate electrode 37 is formed at a recess portion where parts of the n-type $Al_{x2}Ga_{1-x2}N$ layer 733 and the undoped $Al_{x2}Ga_{1-x2}N$ layer 732 are removed by etching; and therefore, an Al composition ratio $x_a$ at the gate interface 73A is equal to the Al composition ratio $x_2$ of the undoped $Al_{x2}Ga_{1-x2}N$ layer 732.

Furthermore,

$x_1/2 \leq x_a < x_1$ and

$x_1 < 0.3$

are satisfied.

The distribution of polarization charge densities in the present implemental example are the same as that shown in Fig. 13(b).

In such an HJFET, a gate current suppression effect can be obtained; and $I_{max}$ and $V_{th}$ are within a desired range. As one example, in the case where the Al composition ratios are set to $x_1=0.25$ and $x_a=0.15$, a gate leak current is suppressed to approximately 0.1% of the related art ($x_1=x_a=0.25$). Furthermore, as compared with the related art, a decrease width of $I_{max}$ is approximately 40% and $V_{th}$ is approximately -2.6 V.

Furthermore, in the present implemental example, the Al composition ratio is constant in the undoped $Al_{x2}Ga_{1-x2}N$ layer 732; and therefore, the Al composition ratio at the gate end $x_a$ is not changed even where a recess depth is slightly fluctuated. Therefore, the HJFET can be excellent in manufacturing stability.

Further, in the present implemental example, a positive ionized impurity charge is generated in the n-type $Al_{x2}Ga_{1-x2}N$ layer 733 located under the ohmic electrodes (35S and 35D). Therefore, the negative polarization charge in the undoped gradient composition $Al_jGa_{1-j}N$ layer 731 is negated, a depletion layer is not generated under the ohmic electrodes, and an increase in ohmic contact resistance is suppressed.

In addition, in the present implemental example, the undoped gradient composition $Al_jGa_{1-j}N$ layer 731 is configured such that the compositions are continuously decreased; however, the present implemental example is not limited to this, and it may be a structure in which the compositions are decreased in a stepwise fashion. Further, it may be a layer whose composition is $x_1$ and constant.

(Eighth Implemental Example)

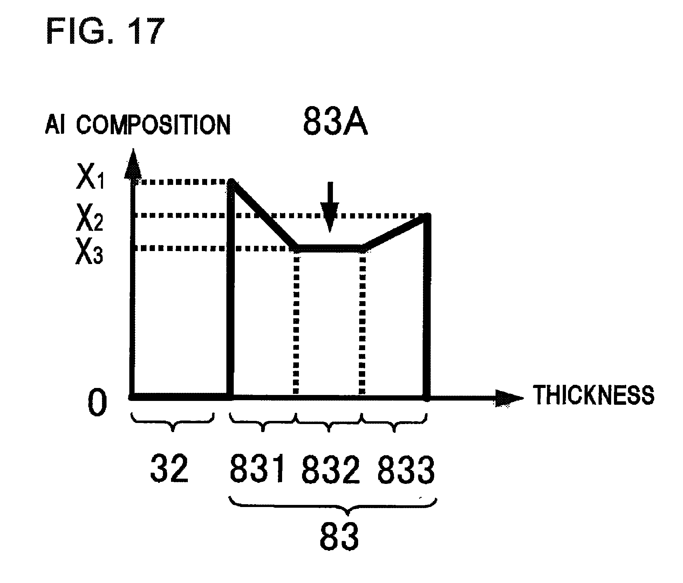

In the fourth implemental example, the negative polarization charge is generated in the undoped gradient composition $Al_dGa_{1-d}N$ layer 431 and the gate current is reduced; on the contrary, there is a problem in that the negative polarization charge is also generated under ohmic electrodes (35S and 35D) and ohmic contact resistance is increased. The present implemental example solves this problem. In an eighth implemental example according to the present invention, the electron supply layer 33 shown in Fig. 8 in the third implemental example is replaced with an electron supply layer ($Al_xGa_{1-x}N$ (0<x<1)) 83 as shown in Fig. 17.

The electron supply layer 83 has an undoped gradient composition $Al_kGa_{1-k}N$ (0<k<1) layer (first electron supply layer) 831, an undoped $Al_{x3}Ga_{1-x3}N$ layer 832 (second electron supply layer) formed on the undoped gradient composition $Al_kGa_{1-k}N$ layer 831, and an n-type gradient composition $Al_mGa_{1-m}N$ layer (0<m<1) (third electron supply layer) 833 formed on the undoped $Al_{x3}Ga_{1-x3}N$ layer 832.

In the undoped gradient composition $Al_kGa_{1-k}N$ layer 831, compositions k are continuously decreased from an interface with the channel layer 32 toward the undoped $Al_{x3}Ga_{1-x3}N$ layer 832. More specifically, the compositions k are decreased from $x_1$ to $x_3$.

The undoped $Al_{x3}Ga_{1-x3}N$ layer 832 is layer whose Al composition is $x_3$ and constant.

In the n-type gradient composition $Al_mGa_{1-m}N$ layer, compositions m ($m>x_3$) are continuously increased from an interface with the undoped $Al_{x3}Ga_{1-x3}N$ layer 832 toward a surface; and more specifically, a maximum composition is increased so as to be $x_2$. An n-type impurity is, for example, Si; and its impurity concentration is, for example, $3.7 \times 10^{18}$ cm$^{-3}$. In addition, it is set to $x_1>x_3$ and $x_2>x_3$. More specifically, it is set to $x_1=0.25$, $x_2=0.2$, and $x_3=0.15$; and each thickness of the respective layers 831 to 833 is 15 nm. AlGaN and GaN are different in lattice constant; however, a total film thickness of 45 nm of the electron supply layer 83 is equal to or less than a critical film thickness for dislocation generation.

In the present implemental example, the gate electrode 37 is formed at a recess portion where parts of the n-type gradient composition $Al_mGa_{1-m}N$ layer 833 and the undoped $Al_{x3}Ga_{1-x3}N$ layer 832 are removed by etching; and therefore, an Al composition ratio $x_a$ at the gate interface 83A is equal to an Al composition ratio $x_3$ of the undoped $Al_{x3}Ga_{1-x3}N$ layer 832.

Further, it is set to

$x_1/2 \leq X_a < x_1$ and

$x_1 \leq 0.3$.

The distribution of polarization charge densities in the present implemental example are the same as Fig. 14(b).

In such an HJFET, a gate current suppression effect can be obtained; and $I_{max}$ and $V_{th}$ are within a desired range. As one example, in the case where the Al composition ratios are set to $x_1=0.25$ and $x_a=0.15$, a gate leak current is suppressed to approximately 0.1% of the related art ($x_1=x_a=0.25$). Furthermore, as compared with the related art, a decrease width of $I_{max}$ is approximately 40% and $V_{th}$ is approximately -2.6 V.

Furthermore, in the present implemental example, the Al composition ratio is constant in the undoped $Al_{x3}Ga_{1-x3}N$ layer 832; and therefore, the Al composition ratio at the gate end $x_a$ is not changed even where a recess depth is slightly fluctuated. Therefore, the HJFET can be excellent in manufacturing stability.

Further, in the present implemental example, a positive polarization charge and a positive ionized impurity charge are generated in the n-type gradient composition $Al_mGa_{1-m}N$ layer 833 located under the ohmic electrodes (35S and 35D). Therefore, a negative polarization charge in the undoped gradient composition $Al_kGa_{1-k}N$ layer 831 is negated, a depletion layer is not generated under the ohmic electrodes, and an increase in ohmic contact resistance is suppressed.

In addition, in the present implemental example, the undoped gradient composition $Al_kGa_{1-k}N$ layer 831 is configured such that the compositions k are continuously decreased; however, the compositions k may be decreased in a stepwise fashion. Similarly, also in the n-type gradient composition $Al_mGa_{1-m}N$ layer 833, the compositions m may be increased in a stepwise fashion.

(Ninth Implemental Example)

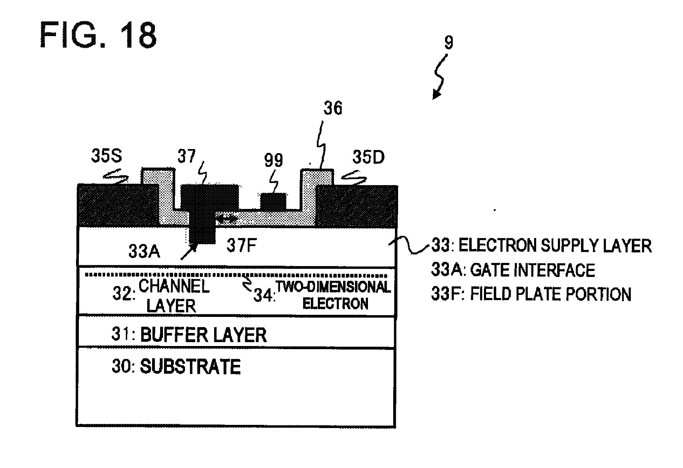

In the third implemental example, since the gate electrode 37 has the peaked shaped field plate portion 37F, the influence of the surface trap is suppressed; on the contrary, there is a problem in that a capacity between the gate and the drain is increased and a gain is decreased. The present implemental example solves this problem. Fig. 18 is a view showing a cross sectional structure of an HJFET 9 of the present implemental example.

As shown in Fig. 18, the HJFET 9 is different from the third implemental example in that a Schottky electrode 99 is formed on an SiN film 36. The rest is the same as the third implemental example.

A metal such as Ti/Pt/Au is deposited at a portion sandwiched between the gate electrode 37 and the drain electrode 35D on the SiN film 36 and liftoff process is performed; and accordingly, the Schottky electrode 99 is formed.

In the present implemental example, a composition $x_2$ on the surface side of an electron supply layer 33 is 0.15, a composition $x_1$ at an interface with a channel layer 32 is 0.2, a composition $x_a$ at an interface with the gate electrode 37 is 0.175.

In such the HJFET 9, the same effects as the third implemental example can be produced.

In the HJFET 9, a gate current suppression effect can be obtained; and $I_{max}$ and $V_{th}$ are within a desired range. As one example, in the case where Al composition ratios are set to $x_1$=0.2 and $x_a$=0.175, a gate leak current is suppressed to approximately 17% of the related art ($x_1$=$x_a$=0.2). Furthermore, as compared with the related art, a decrease width of $I_{max}$ is approximately 13% and $V_{th}$ is approximately -2.3 V.

Further, in the present implemental example, the Schottky electrode 99 is connected to a source; and accordingly, it serves as a so-called Faraday shield. That is, an electrical coupling between the gate and the drain is shielded; and a gain and isolation characteristics are improved. The Schottky electrode 99 may be connected to the gate. In this case, it serves as a so-called field plate, and a gate breakdown voltage is further improved.

(Tenth Implemental Example)

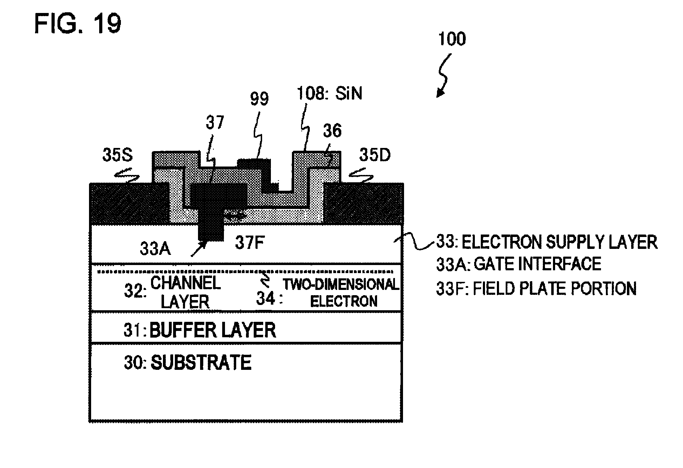

In the third implemental example, since the gate electrode 37 has the peaked shaped field plate portion 37F, the influence of the surface trap is suppressed; on the contrary, there is a problem in that a capacity between the gate and the drawn is increased and a gain is decreased. The present implemental example solves this problem. Fig. 19 is a view showing a cross sectional structure of an HJFET 100 of the present implemental example.

As shown in Fig. 19, the HJFET 100 is different from the third implemental example in that the HJFET 100 has an SiN film (dielectric film) 108 formed on an SiN film 36 and a Schottky electrode 99 formed on the SiN film 108. The rest is the same as the third implemental example.

The SiN film 108 is formed on the SiN film 36 using a PECVD method, for example; and its thickness is approximately 200 nm. A metal such as Ti/Pt/Au is deposited at a portion sandwiched between a gate electrode 37 and a drain electrode 35D on the SiN film 108 and liftoff process is performed; and accordingly, the Schottky electrode 99 is formed.

In such the HJFET 100, the same effects as the ninth implemental example can be produced. In addition to this, the present implemental example is a configuration in which the SiN film 108 is sandwiched between the gate electrode 37 and the Schottky electrode 99. That is, at least one part of the gate electrode 37 or the Schottky electrode 99 is in a state being superposed via the SiN film 108 in the surface perpendicular to the substrate 30. Therefore, the Schottky electrode 99 surrounds at least a part of the gate electrode 37; and consequently, a shielding effect between the gate and the drain is improved and a gain and isolation characteristics are further improved.

As described above, the present invention is described in line with the above mentioned implemental examples; however, the present invention is not limited to only the above mentioned embodiments, and it will be understood that the present invention includes various embodiments in conformity with the principle of the present invention. For example, AlGaN is used as the electron supply layer in the above mentioned implemental examples; however, the electron supply layer may include AlGaN as an essential component, for example, it may be one which includes indium aluminum gallium nitride (InAlGaN).

Further, the electron supply layer may be a superlattice layer.

Furthermore, the above mentioned implemental examples use GaN as the channel material; however, it may be other III group nitride semiconductor whose band gap is smaller than the electron supply layer. For example, indium nitride (InN), indium gallium nitride (InGaN), AlGaN, indium aluminum nitride (InAlN), and InAlGaN may be used.

Further, the above mentioned implemental examples use SiN as the dielectric film; however, other dielectric may be used. For example, silicon dioxide ($SiO_2$) and silicon nitride oxide (SiON) may be used.

Furthermore, the above mentioned implemental examples use SiC as the substrate material; however, other substrate may be used. For example, sapphire, Si, and GaN may be used.

In addition, the ninth and the tenth implemental examples exemplify the configurations in which the Schottky electrode is formed in the semiconductor device with the gate recess structure; however, the Schottky electrode is not limited to devices with the gate recess structure. For example, it may be applied to the semiconductor device described in the first implemental example. In such cases, an apparatus gain and isolation characteristics can be improved.

**Claims**

1. A semiconductor device, comprising:

   a channel layer;
   an electron supply layer which forms a heterojunction with said channel layer, and contains $In_zAl_xGa_{1-z-x}N$ ($0 \le z < 1$, $0 < x < 1$, and $0 < x+z < 1$); and
   a source electrode, a drain electrode, and a gate electrode, those of which are formed in contact with said electron supply layer,

   wherein an Al composition ratio $x_1$ ($x_1 > 0$) at an interface between said electron supply layer and said channel layer, and an Al composition ratio $x_a$ ($x_a > 0$) at an interface between said electron supply layer and said gate electrode are set to
   $x_1/2 \le x_a < x_1$ and
   $x_1 \le 0.3$.

2. The semiconductor device according to claim 1,
   wherein the composition ratios are set to $x_1 - 0.01 > x_a$.

3. The semiconductor device According to claim 2,
   wherein said electron supply layer has a layer in which the Al composition ratios are continuously decreased from $x_1$ to $x_a$, from the interface with said channel layer toward the side of said gate electrode.

4. The semiconductor device according to claim 2,
   wherein said electron supply layer has a plurality of layers in which the Al composition ratios are decreased in a stepwise fashion from $x_1$ to $x_a$, from the interface with said channel layer toward the side of said gate electrode.

5. The semiconductor device according to claim 2,
   wherein said electron supply layer is formed with a concave recess portion, and
   said gate electrode is formed so as to embed said recess portion.

6. The semiconductor device according to claim 5,
   wherein said electron supply layer has a first electron supply layer containing AlGaN whose Al composition ratio at the interface with said channel layer is $x_1$, and
   a second electron supply layer which is formed on said first electron supply layer and is made of an AlGaN layer whose Al composition ratio is $x_a$ and constant;
   said recess portion is formed in said second electron supply layer; and
   said gate electrode is in contact with said second electron supply layer.

7. The semiconductor device according to claim 6,
   further comprising a third electron supply layer which is formed on said second electron supply layer, and contains AlGaN whose Al composition ratio is larger than $x_a$, and
   wherein said recess portion is formed across said second electron supply layer and said third electron supply layer; and

said gate electrode is in contact with said second electron supply layer.

8. The semiconductor device according to claim 5,
   wherein said electron supply layer, which is in contact with said source electrode and said drain electrode, has an uppermost layer which contains n-type AlGaN.

9. The semiconductor device according to claim 5,
   further comprising a dielectric film which is formed on said electron supply layer, and
   wherein said gate electrode is extended in a peaked shape to the side of said drain electrode, and has a field plate portion formed on an upper portion of said dielectric film.

10. The semiconductor device according to claim 2,
    further comprising: a dielectric film which is formed on said electron supply layer; and
    a Schottky electrode which is formed on said dielectric film,
    said Schottky electrode being formed at a position sandwiched between said gate electrode and said drain electrode.

11. The semiconductor device according to claim 10,
    further comprising a second dielectric film which is formed on said gate electrode and said dielectric film, and
    wherein said Schottky electrode is formed on said second dielectric film.

FIG. 1

1

18: SiN

15S: SOURCE ELECTRODE    17: GATE ELECTRODE    15D: DRAIN ELECTRODE

13A

13: ELECTRON SUPPLY LAYER
13A: GATE INTERFACE $(x=x_a)$

12: CHANNEL LAYER    14: TWO-DIMENSIONAL ELECTRON

11: BUFFER LAYER

10: SUBSTRATE

# FIG. 2

(a)

AI COMPOSITION x

12    13

$x_1$

$x_2$

0

13A($x=x_a$)

THICKNESS

t

(b)

POLARIZATION
CHARGE DENSITY Pv

$Ps=+\alpha x_1$

Ps: POLARIZATION CHARGE
SURFACE DENSITY

0

THICKNESS

$-\alpha(x_1-x_2)/t$

FIG. 3

## FIG. 4

Graph: REVERSE DIRECTION GATE CURRENT (mA/mm) vs AI COMPOSITION RATIO AT GATE END Xa (%)

AI COMPOSITION RATIO AT CHANNEL END : $x_l$=20%

$x_a$=20% (RELATED ART)

$x_a$=19%

$x_a$=17%

$x_a$=14%

Y-axis values: 1.E-02, 1.E-03, 1.E-04, 1.E-05, 1.E-06, 1.E-07

X-axis values: 10, 15, 20, 25

# FIG. 5

## FIG. 6

# FIG. 7

AI COMPOSITION

(a)

POLARIZATION CHARGE
SURFACE DENSITY Ps

(b)

FIG. 8

33: ELECTRON SUPPLY LAYER
33A: GATE INTERFACE
37F: FIELD PLATE PORTION

FIG. 9

# FIG. 10

# FIG. 11

AI COMPOSITION RATIO AT CHANNEL END: x1=20%

CALCULATED VALUE

STRUCTURE 1

STRUCTURE 2

STRUCTURE 3

MAXIMUM DRAIN CURRENT (mA/mm)

AI COMPOSITION RATIO AT GATE END Xa (%)

# FIG. 12

# FIG. 13

**Al COMPOSITION x**

43

32    431    432

(a)

43A($x_a = x_2$)

$X_1$

$X_2$

0                    THICKNESS

t1    t2

(b)

**POLARIZATION CHARGE DENSITY Pv**

$Ps = + \alpha X_1$    Ps: POLARIZATION CHARGE SURFACE DENSITY

0                    THICKNESS

$-\alpha (X_1 - X_2)/t1$

# FIG. 14

AI COMPOSITION

(a)

53

32 531 532 533

$X_1$
$X_2$
$X_3$

53A

0 THICKNESS

t1 t2 t3

POLARIZATION
CHARGE DENSITY Pv

$Ps=+\alpha X_1$

Ps: POLARIZATION CHARGE
SURFACE DENSITY

(b)

$+\alpha (X_2-X_3)/t3$

0 THICKNESS

$-\alpha (X_1-X_3)/t1$

# FIG. 15

AI COMPOSITION

63A

xa

$X_1$
$X_3$
$X_2$

0                                          THICKNESS

32          631    632

63

FIG. 16

## FIG. 17

AI COMPOSITION 83A

$X_1$
$X_2$
$X_3$

0

THICKNESS

32   831 832 833

83

# FIG. 18

9

36

35S   37   99   35D

33A   37F

33: ELECTRON SUPPLY LAYER
33A: GATE INTERFACE
33F: FIELD PLATE PORTION

32: CHANNEL
LAYER

34: TWO-DIMENSIONAL
ELECTRON

31: BUFFER LAYER

30: SUBSTRATE

FIG. 19

100

# FIG. 20

208: SiN

SOURCE
205S: ELECTRODE

GATE
207: ELECTRODE

DRAIN
205D: ELECTRODE

ELECTRON
203: SUPPLY LAYER        203A

202: CHANNEL LAYER        204: TWO-DIMENSIONAL ELECTRON

201: BUFFER LAYER

200: SUBSTRATE

# FIG. 21

(a)

AI COMPOSITION

202    203

203A

b

0                                    THICKNESS

t

(b)

POLARIZATION
CHARGE SURFACE DENSITY Ps
$+\alpha b$

0                                    THICKNESS

## INTERNATIONAL SEARCH REPORT

| | International application No. |
|---|---|
| | PCT/JP2007/000037 |

**A. CLASSIFICATION OF SUBJECT MATTER**
*H01L21/338*(2006.01)i, *H01L29/06*(2006.01)i, *H01L29/778*(2006.01)i,
*H01L29/80*(2006.01)i, *H01L29/812*(2006.01)i

According to International Patent Classification (IPC) or to both national classification and IPC

**B. FIELDS SEARCHED**

Minimum documentation searched (classification system followed by classification symbols)
H01L21/338, H01L29/06, H01L29/778, H01L29/80, H01L29/812

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2003-229439 A  (Shin-Etsu Handotai Co.,<br>Ltd.),<br>15 August, 2003 (15.08.03),<br>Par. Nos. [0017] to [0022]<br>(Family: none) | 1-4<br>5,6,8-11<br>7 |
| Y | JP 2002-289837 A  (Matsushita Electric<br>Industrial Co., Ltd.),<br>04 October, 2002 (04.10.02),<br>Fig. 3<br>& EP 1246256 A2          & US 2002/0139995 A1 | 5,6,8,9 |
| Y | JP 2001-230263 A  (NEC Corp.),<br>24 August, 2001 (24.08.01),<br>Fig. 2<br>(Family: none) | 9 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>19 April, 2007 (19.04.07) | Date of mailing of the international search report<br>01 May, 2007 (01.05.07) |
|---|---|
| Name and mailing address of the ISA/<br>Japanese Patent Office | Authorized officer |
| Facsimile No. | Telephone No. |

Form PCT/ISA/210 (second sheet) (April 2005)

EP 1 983 563 A1

## INTERNATIONAL SEARCH REPORT

| | International application No. |
|---|---|
| | PCT/JP2007/000037 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2004-214471 A  (NEC Corp.),<br>29 July, 2004 (29.07.04),<br>Fig. 1<br>& WO 2004/061978 A1      & US 2006/0043415 A1 | 10,11 |
| Y | JP 2000-003919 A  (NEC Corp.),<br>07 January, 2000 (07.01.00),<br>Fig. 1<br>& US 6100571 A | 10,11 |
| A | JP 2003-151996 A  (Nichia Chemical Industries,<br>Ltd.),<br>23 May, 2003 (23.05.03),<br>Fig. 4<br>(Family: none) | 1-11 |
| E,X | JP 2007-088252 A  (Toyoda Gosei Co., Ltd.),<br>05 April, 2007 (05.04.07),<br>Par. Nos. [0020] to [0032]<br>(Family: none) | 1-4 |
| E,X | JP 2007-067240 A  (Toshiba Corp.),<br>15 March, 2007 (15.03.07),<br>Par. Nos. [0025] to [0062]<br>(Family: none) | 1,2,4,5-9 |
| P,X | JP 2006-261642 A  (Matsushita Electric<br>Industrial Co., Ltd.),<br>28 September, 2006 (28.09.06),<br>Fig. 1<br>& US 2006/0180831 A1 | 1-4 |

Form PCT/ISA/210 (continuation of second sheet) (April 2005)